# EUROPEAN PATENT SPECIFICATION

(11) **EP 0 344 055 B1**
(45) Date of publication and mention of the grant of the patent: **26.07.1995**
(21) Application number: 89401404.2
(22) Date of filing: 23.05.1989
(51) Int. Cl.: H01L 27/02, H01L 23/52

(54) **Semiconductor integrated circuit device**
Integrierte Halbleiterschaltungsanordnung
Dispositif de circuit intégré semi-conducteur

(30) Priority: 23.05.1988 JP 125454/88
(43) Date of publication of application: 29.11.1989
(73) Proprietor: FUJITSU LIMITED, Kawasaki-shi, Kanagawa 211 (JP)
(72) Inventor: Okano, Yoshiaki, Tokyo 110 (JP)
(74) Representative: Joly, Jean-Jacques

(56) References cited:
- FR-A- 2 508 255
- PATENT ABSTRACTS OF JAPAN, vol. 12, no. 168 (E-611)[3015], 20th May 1988 & JP-A-62 279 656

## Description

### BACKGROUND OF THE INVENTION

The present invention generally relates to a semiconductor integrated circuit device, and particularly to a semiconductor integrated circuit device having bonding pads arranged in a peripheral portion of a semiconductor chip, and peripheral circuits arranged in the vicinity of bonding pads. More particularly, the present invention relates to an improvement in the arrangement of bonding pads and chip peripheral areas used for forming a peripheral circuit such as an input buffer circuit, an output buffer circuit, or a bi-directional buffer circuit connected to bonding pads.

Conventionally, a plurality of pairs of bonding pads and peripheral circuits are arranged in a peripheral portion of a semiconductor chip. That is, one bonding pad is associated with one peripheral circuit. The above-mentioned arrangement of bonding pads and peripheral circuits creates easy layout design (repetition of one layout pattern) and a large degree of freedom to use bonding pads and related peripheral circuits.

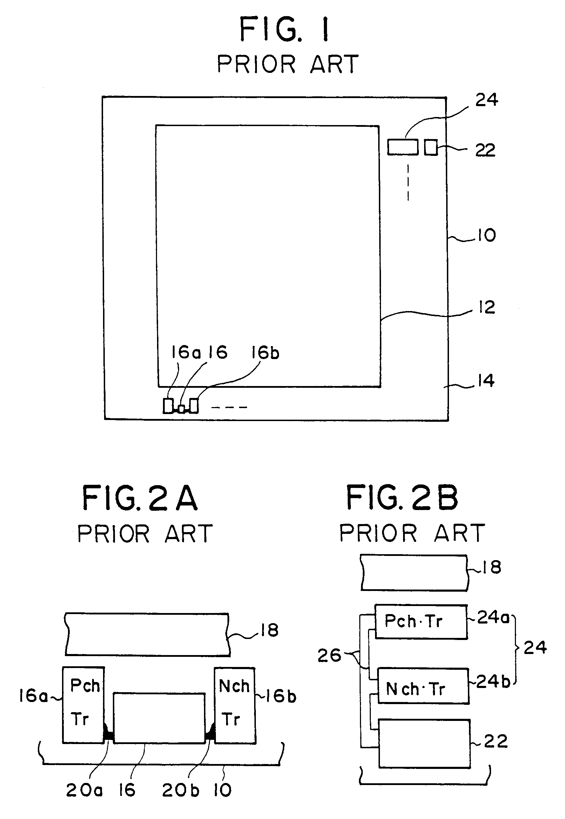

Referring to FIG.1, there is illustrated a conventional semiconductor integrated circuit device, which includes a semiconductor chip 10, an internal logic circuit area 12, and a chip peripheral area 14. The internal logic circuit area 12 includes a plurality of basic cells arrayed in matrix form, for example. In the chip peripheral area 14 surrounding the internal logic circuit area 12, there are arranged bonding pads 16, and peripheral circuits each having a P-channel transistor area 16a and an N-channel transistor area 16b used for forming a peripheral circuit (or an input/output cell). As is illustrated, one peripheral circuit made up of the transistor areas 16a and 16b is provided for each of the bonding pads 16.

FIG.2A is an enlarged view of the bonding pad 16 and the P-channel and N-channel transistor areas 16a and 16b illustrated in FIG.1. The P-channel and N-channel transistor areas 16a and 16b are located on both sides of the bonding pad 16 along an end of the semiconductor chip 10. The P-channel transistor area 16a and N-channel transistor area 16b are connected to the bonding pad 16 by connecting members 20a and 20b, respectively. A power supply line 18 is arranged in the vicinity of the P-channel and N-channel transistor areas 16a and 16b and the bonding bad 16 along the end of the semiconductor chip 10.

Turning now to FIG.1, there are also a bonding pad 22 and a peripheral circuit area 24. FIG.2B is an enlarged view of those parts. Referring to FIG.2B, there are arranged the bonding pad 22, the peripheral circuit area 24 made up of N-channel and P-channel transistor areas 24b and 24a, and the power supply line 18 in this order from the end of the semiconductor chip 10. The P-channel and N-channel transistor areas 24a and 24b and the bonding pads 22 are mutually connected by connecting lines 26, as shown in FIG.2B. One peripheral circuit is formed by the P-channel and N-channel transistor areas 24a and 24b.

Generally, the size of an output transistor used for forming an output buffer circuit must be large in order to obtain a high driveability for an external load. Even in an input buffer circuit, there is a need for a transistor having a large driveability. For example, a large number of flip-flops is driven by an external clock signal. The above holds true for a bi-directional circuit (an input and output circuit). The larger the size of output transistors, the larger the peripheral circuit area of the semiconductor chip. In the arrangement of FIG.2A, the number of bonding pads 16 decreases with an increase of each of the P-channel and N-channel transistor areas 16a and 16b. In the arrangement of FIG.2B, the internal logic circuit area 12 (FIG.1) reduces with an increase of each of the P-channel and N-channel transistor areas 24a and 24b. This is because the area of each of the P-channel and N-channel transistor areas 24a and 24b must be increased toward the internal logic circuit 12 in order to increase the driveability. It can be seen from the above that there is room for improvement in arrangement of bonding pads and chip peripheral areas.

Another example of a semiconductor chip topography is disclosed in FR-A-2 508 255, wherein the relative configuration of the transistor areas in the peripheral circuit with respect to the bonding pads corresponds to the preamble of claim 1.

### SUMMARY OF THE INVENTION

It is therefore a general object of the present invention to provide a novel and useful semiconductor integrated circuit device in which the above-mentioned disadvantages are eliminated.

A more specific object of the present invention is to provide a semiconductor integrated circuit device having a reduced chip peripheral area where a peripheral circuit such as an input circuit and an output circuit is effectively formed together with bonding pads.

Another object of the present invention is to provide a semiconductor integrated circuit device having an increased internal logic circuit area to thereby enhance the integration density.

The above objects of the present invention are achieved by a semiconductor integrated circuit device as claimed in claim 1.

Other objects, features and advantages of the present invention will become apparent from the following detailed description when read in conjunction with the accompanying drawings.

### BRIEF DESCRIPTION OF THE DRAWINGS

FIG.1 is a schematic plan view of a semiconductor chip of a conventional semiconductor integrated circuit device;
FIG.2A is a schematic plan view of a conventional arrangement of a bonding pad and transistor areas;
FIG.2B is a schematic plan view of another conventional arrangement of a bonding pad and transistor areas;
FIG.3 is a schematic plan view of an essential part of a first embodiment;
FIG.4A is a detailed plan view of the essential part of the first embodiment shown in FIG.3;
FIG.4B is a detailed plan view of an essential part of the conventional arrangement;
FIG.4C is a circuit diagram of the structure of FIG.4A;
FIG.4D is a circuit diagram of the structure of FIG.4B;
FIG.5A is a plan view of a semiconductor chip of the present invention;
FIG.5B is a plan view of a conventional semiconductor chip;
FIG.6 is a schematic plan view of an essential part of a second embodiment of the present invention;
FIG.7 is a detailed plan view of the essential part of the second embodiment illustrated in FIG.6; and
FIG.8 is a detailed plan view of an essential part of a third embodiment of the present invention.

### DESCRIPTION OF THE PREFERRED EMBODIMENTS

A description is given of a first preferred embodiment of the present invention.

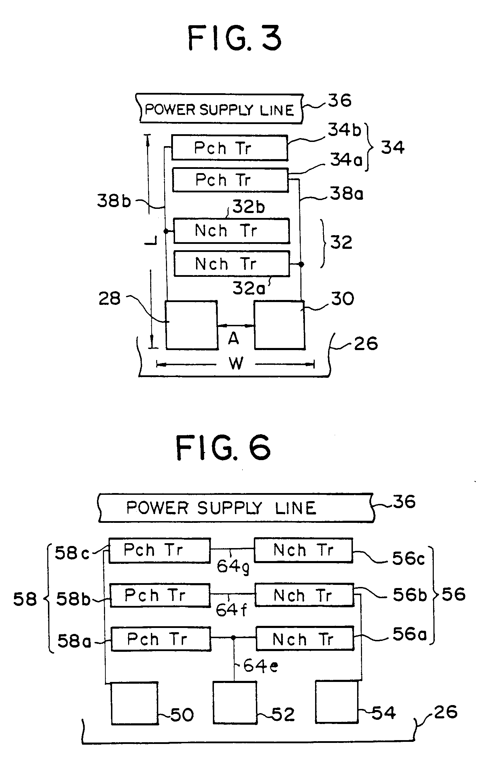

Referring to FIG.3, there is illustrated an essential part of the first embodiment of the present invention. Referring to FIG.3, a pair of neighboring bonding pads 28 and 30 is arranged in the vicinity of an end of a semiconductor chip 26, or in an outer portion of a chip peripheral area. With respect to the paired bonding pads 28 and 30, there are arranged an N-channel transistor area 32 having two N-channel transistor areas 32a, 32b, and a P-channel transistor area 34 having two P-channel transistor areas 34a and 34b in this order from the bonding pads 28 and 30. The N-channel and P-channel transistor areas 32 and 34 are arranged side by side in the direction perpendicular to the direction of the arrangement of the bonding pads 28 and 30. The N-channel transistor area 32b and the P-channel transistor area 34a are separated from each other by a distance equal to at least the minimum distance required to ensure the electrical insulation therebetween. The N-channel transistor area 32 has n⁺-type impurity diffused regions formed in an p-type semiconductor substrate of the semiconductor chip 26. The P-channel transistor area 34 has p⁺-type impurity diffused regions formed in a n-type well formed in the p-type semiconductor substrate. The transistor areas 32a, 32b, 34a and 34b are used for forming peripheral circuits which are to be connected to the bonding pads 28 and 30. Examples of the peripheral circuits are an input buffer circuit, an output buffer circuit and a bi-directional buffer circuit. In the following description, output buffers are formed by the transistor areas 32a, 32b, 34a and 34b. It is particularly noted that each of the transistor areas 32a, 32b, 34a and 34b is continuously formed along the arrangement of the bonding pads 28 and 30. That is, each of the transistor areas 32a, 32b, 34a and 34b is continuously formed, while the bonding pads 28 and 30 are separated at a distance A, which corresponds to the minimum separation distance determined in view of working requirements for wire bonding (approximately 120 »m, for example). As a result of the continuous arrangement of each transistor area, a portion of the chip peripheral area corresponding to the distance A is effectively used to form transistors. The transistor areas 32a, 32b, 34a and 34b are mutually connected to form desired peripheral circuits connected to the bonding pads 28 and 30. A power supply line 36 is disposed in the vicinity of the P-channel transistor area 34b.

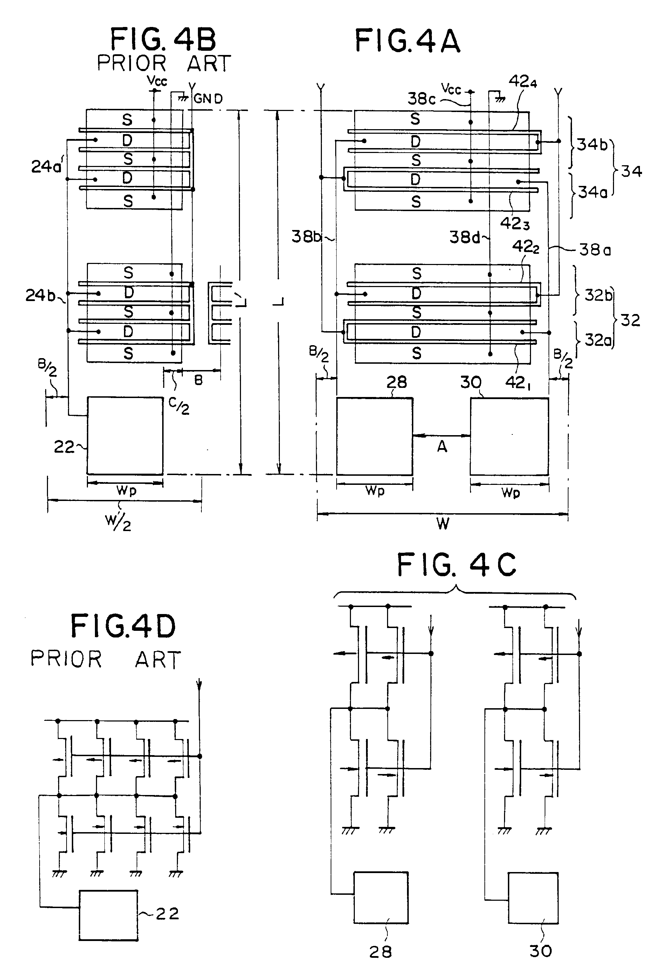

FIG.4A is a detailed plan view of the layout of FIG.3. Referring to FIG.4A, each of the N-channel transistor areas 32a and 32b can provide four N-channel semiconductor metal oxide (hereinafter simply referred as as MOS) transistors. Similarly, each of the P-channel transistor areas 34a and 34b can provide four P-channel MOS transistors. L-shaped gate electrodes 42₁, 42₂, 42₃ and 42₄ related to the transistor areas 32a, 32b, 34a and 34b, respectively, are formed on an insulating layer (not shown) formed on top of the semiconductor chip 26. The drain areas (D) of the N-channel transistor area 32a and the P-channel transistor area 34a are connected to the bonding pad 30 through an interconnection line 38a. The drain areas of the the N-channel transistor area 32b and the P-channel transistor area 34b are connected to the bonding pad 28 through an interconnection line 38b. Three source areas of the P-channel transistor areas 34a and 34b are supplied with a positive power source voltage Vcc through an interconnection line 38c. Three source areas of the N-channel transistor areas 32a and 32b are connected to ground through an interconnection line 38d. The gate electrodes 42₁ and 42₃ are mutually connected through an interconnection line (not shown) and connected to an internal logic circuit area (not shown in FIG.4A). Similarly, the gate electrodes 42₂ and 42₄ are mutually connected through an interconnection line (not shown) and connected to an internal logic circuit formed in the internal logic circuit area. Thereby, two cascaded CMOS inverters are connected to each of the bonding pads 28 and 30.

FIG.4B is a detailed plan view of the conventional arrangement shown in FIG.2B. FIG.4B is drawn on a scale identical to that for FIG.4A. In order to form a circuit equivalent to the circuit of FIG.4A, two N-channel transistor areas 24b and two P-channel transistor areas 24a must be used. Half of the circuit is illustrated in FIG.4B for the sake of simplicity. In FIG.4A, a width W corresponds to a length of an arrangement of the N-channel and P-channel transistor areas 32 and 34 along the end of the semiconductor chip 26. That is, the width W is defined as follows: W = 2 x Wp + A + B, where Wp is the width of each of the bonding pads 28 and 30, B is the separation distance between the adjacent N-channel transistor areas (or P-channel transistor areas), and A is the separation distance between the bonding pads 28 and 30. Similarly, a distance W′ is defined for the conventional arrangement of FIG.4B. The width W′ is defined as follows: W′ = 2 x (Wp + B + C/2), where C is twice as long as the distance between an end of the bonding pad 22 and an end of the N-channel transistor area 24b (or the P-channel transistor area 24a). It is also said that the width of each of the pairs of the N-channel and P-channel transistor areas 32 and 34 is equal to or smaller than the distance between ends of the two bonding pads 28 and 30 other than opposed ends thereof. In the embodiment of FIG.4A, the width W is equal to approximately 325 »m, for example. On the other hand, in the conventional arrangement of FIG.4B, the width W′/2 is approximately 200 »m and therefore width W′ is approximately 400 »m. In FIG.4A, a length L is defined as the length between an end of the bonding pad 28 or 30 close to the end of the semiconductor chip 26 and an end of the P-channel transistor area 34b close to the power supply line 36 (FIG.3). Similarly, a length L′ is defined for the arrangement of FIG.4B. The length L is approximately identical to the length L′, and is approximately 500 »m, for example.

FIG.4C is a circuit diagram of the structure illustrated in FIG.4A, and FIG.4D is a circuit diagram of the conventional structure shown in FIG.4B. It is noted that each transistor shown in FIG.4C has a driveability greater than each transistor shown in FIG.4D.

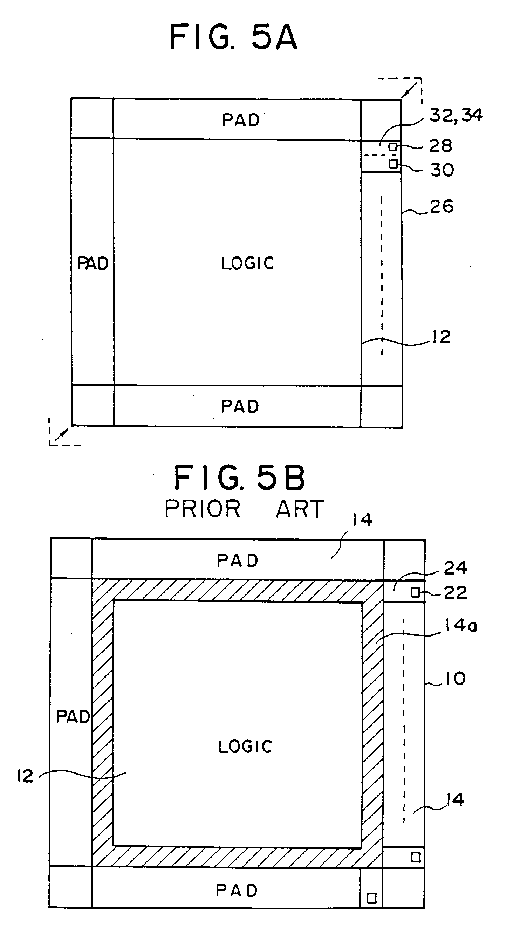

FIG.5A is a plan view of the semiconductor chip 26 of the first embodiment, and FIG.5B is a plan view of the semiconductor chip 10 having the conventional arrangement shown in FIGS.2B and 4B. In the case where the same number of bonding pads is arranged along one end of the semiconductor chip, the semiconductor chip 26 is made smaller than the conventional semiconductor chip 10, as indicated by broken lines and related arrows shown in FIG.5A. In FIG.5B, there is a possibility that a hatched area 14a interposed in the chip peripheral area 14 and the internal logic circuit area 12 may be left as a wasteful area.

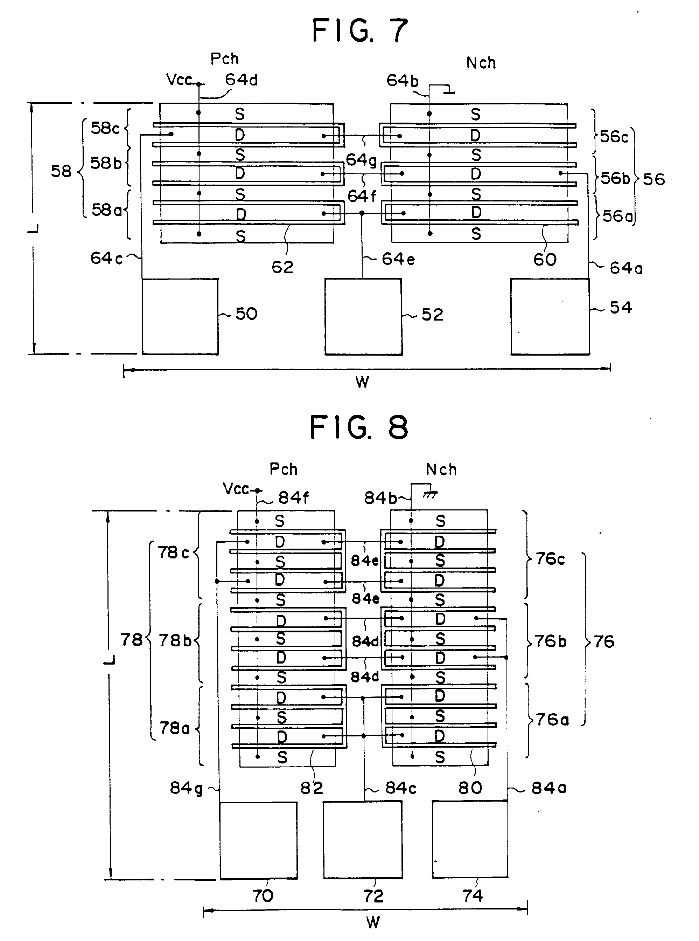

A description is given of a second preferred embodiment of the present invention with reference to FIGS.6 and 7. An essential feature of the second embodiment is that a pair of N-channel transistor area 56 and P-channel transistor area 58 arranged along an end of the semiconductor chip 26 is provided for three neighboring bonding pads 50, 52 and 54. Particularly, the second embodiment is intended to reduce the length L of a chip peripheral circuit area. The distance between the neighboring bonding pads such as bonding pads 50 and 52 is set equal to a distance which is larger than the minimum separation distance and is approximately identical to that for the conventional arrangement of FIG.4B, for example. The N-channel and P-channel transistor areas 56 and 58 are arranged side by side in the direction corresponding to the arrangement of the bonding pads 50, 52 and 54. The N-channel transistor area 56 has three N-channel transistor areas 56a, 56b and 56c, each of which presents two N-channel MOS transistors. Similarly, the P-channel transistor area 58 has three P-channel MOS transistor areas 58a, 58b and 58c, each of which presents two P-channel MOS transistors. Three gate electrodes 60 are provided for the N-channel transistor area 56, and three gate electrodes 62 are provided for the P-channel transistor area 58. The drain area of the N-channel transistor area 56b is connected to the related bonding pad 54 through an interconnection line 64a. The source areas of the N-channel transistor areas 56a, 56b and 56c are connected to ground through an interconnection line 64b. The source areas of the N-channel transistor areas 56a, 56b and 56c are connected to those of the P-channel transistor areas 58a, 58b and 58c, through interconnection lines 64e, 64f and 64g, respectively. The source areas of the P-channel transistor areas 58a, 58b and 58c are supplied with the positive power source voltage Vcc. The drain area of the P-channel transistor area 58c is connected to the bonding pad 50 through an interconnection line 64c. The drain areas of the N-channel transistor area 56a and P-channel transistor area 58a are connected to the bonding pad 52 through the interconnection line 64e. In this manner, three output buffer circuits each including two cascaded CMOS inverters are formed and connected to each of the bonding pads 50, 52 and 54. The width W of the arrangement of FIG.6 is approximately 625 »m, for example, and the length L is approximately 350 »m. On the other hand, in the case where the same output buffer circuits are constructed by the conventional arrangement shown in FIG.4A, the width W′ is approximately 600 »m (= 3 x 200), and the length L′ is approximately 500 »m. It can be seen that according to the second embodiment, it becomes possible to extremely reduce the length of a chip peripheral circuit, although the width W thereof is approximately equal to or slightly exceeds the width W′ for the conventional arrangement.

A description is given of a third preferred embodiment of the present invention with reference to FIG.8. The third embodiment corresponds to a variation of the second embodiment shown in FIGS.6 and 7. A pattern of a peripheral circuit is elongated in the length direction. In other words, the separation distance between the neighboring bonding pads in the third embodiment is reduced, as compared with the second embodiment. Referring to FIG.8, a pair of N-channel transistor area 76 and P-channel transistor area 78 is provided for three neighboring bonding pads 70, 72 and 74. The separation distance between the neighboring bonding pads such as the bonding pads 70 and 72 is set equal to the minimum separation distance, for example.

Each of the N-channel and P-channel transistor areas 76 and 78 is smaller in width than each of N-channel and P-channel transistor areas 56 and 58 shown in FIG.7. Therefore, in order to obtain almost the same driveability, it is required to use an increased number of transistors. The N-channel transistor area 76 has three N-channel transistor areas 76a, 76b and 76c, each provided with one gate electrode 80 having four extensions. Each of the three N-channel transistor areas 76a, 76b and 76c presents four N-channel MOS transistors. Similarly, the P-channel transistor area 78 has three P-channel transistor areas 78a, 78b and 78c, each provided with one gate electrode 82 having four extensions. Each of the three P-channel transistor areas 78a, 78b and 78c presents four P-channel MOS transistors.

The drain areas of the N-channel transistor area 76b are connected to the bonding pad 74 through an interconnection line 84a. The drain areas of the N-channel transistor area 76a are connected to the drain areas of the P-channel transistor area 78a through interconnection lines 84c, and to the bonding pad 72 therethrough. The drain areas of the N-channel transistor area 76c are connected to the drain areas of the P-channel transistor area 78c through interconnection lines 84e. The drain areas of the P-channel transistor area 78c are connected to the bonding pad 70 through an interconnection line 86g. The source areas of the N-channel transistor area 76 are connected to ground through an interconnection line 84b. The source areas of the P-channel transistor area 78 are supplied with the positive power source voltage Vcc through an interconnection line 84f. With the above-mentioned structure and interconnection lines, output buffer circuits each made up of four CMOS inverters are formed for the bonding pads 70, 72 and 74.

The width W of the arrangement of FIG.8 is set equal to approximately 425 »m, for example, and the length L thereof is set equal to approximately 500 »m. On the other hand, the equivalent output buffer circuit may be constructed by using the conventional arrangement of FIG.4B, where the width W′ is approximately 600 »m and the length L′ is almost identical to the length L.

The interconnection lines used in the aforementioned embodiments are provided so as to form output buffer circuits. It is easy to construct input buffer circuits or bi-directional input circuits simply by changing the pattern of the interconnection lines. That is, it is preferable to form the present invention as a master slice type semiconductor integrated circuit. Further, the aforementioned interconnection lines may be constructed by a single layer structure or a multilayer structure. It is possible to arrange different types of the aforementioned embodiments in a single semiconductor chip. It is possible to interchange the N-channel transistor areas and P-channel transistor areas used in the aforementioned embodiments. For example, it is possible to interchange the N-channel and P-channel transistor areas 32 and 34.

The present invention is particularly advantageous to a multi-bit semiconductor integrated circuit device such as a 16 bit or 32-bit device. For example, it becomes possible to efficiently arrange bonding pads and related peripheral circuits relating to signals of the same type consisting of a number of bits, such as an address signal and a data signal. Further, one peripheral circuit pattern is provided for a plurality of bits, or in other words, peripheral circuit patterns are integrally formed. Thus, it becomes possible to enhance resistance to an electrostatic voltage and latch-up. It is also possible to form a protection circuit together with an output buffer circuit by using P-channel and N-channel transistor areas.

## Claims

1. A semiconductor integrated circuit device comprising a semiconductor chip (26) having an internal logic circuit area (12) and a chip peripheral area surrounding said internal logic circuit area, and bonding pads (28, 30; 50, 52, 54; 70, 72, 74) adapted for interfacing with an external device, said bonding pads being arranged in a first direction in an outer portion of said chip peripheral area; a pair of N-channel and P-channel transistor areas (32, 34; 56, 58; 76, 78) formed continuously in said first direction and containing a plurality of transistors being provided for two or more neighboring bonding pads (28, 30; 50, 52, 54; 70, 72, 74) among said bonding pads and being arranged adjacent to said two or more neighboring bonding pads in said chip peripheral area, said transistors of said pair of transistor areas being connected to a peripheral circuit interfacing with said external device through said two or more neighboring bonding pads, said peripheral circuit being connected to said two or more neighboring bonding pads, each one of said N- and P-channel transistor areas (32, 34; 56, 58; 76, 78) extending over the distance (A) separating said two neighboring pads, characterized in that said transistors in said transistor area are connected together to form buffer circuits that are connected, respectively, to each of said two or more neighboring bonding pads.

2. A semiconductor integrated circuit device as claimed in claim 1, characterized in that said pair of N-channel and P-channel transistor areas (32, 34) is provided for two neighboring bonding pads (28, 30), and that one of said paired N-channel and P-channel transistor areas is formed directly adjacent to said two neighboring bonding pads, and the other transistor area is formed on a side of said one transistor area opposite to a side thereof facing said two neighboring bonding pads.

3. A semiconductor integrated circuit device as claimed in claim 2, characterized in that said pair of N-channel and P-channel transistor areas (32, 34) is arranged side by side in the direction perpendicular to said first direction.

4. A semiconductor integrated circuit device as claimed in claims 2 or 3, characterized in that the width of each of said paired N-channel and P-channel transistor areas (32, 34) is equal to or smaller than the distance between the sides of said two bonding pads (28, 30) that are not opposed.

5. A semiconductor integrated circuit device as claimed in any of claims 2 to 4, characterized in that said N-channel transistor area (32) of said pair is formed directly adjacent to said two neighboring bonding pads (28, 30), and said P-channel transistor area (34) of said pair is formed on the side of said N-channel transistor area (32) opposite to the side thereof facing said two neighboring bonding pads.

6. A semiconductor integrated circuit device as claimed in claim 1, characterized in that said pair of N-channel and P-channel transistor areas (56, 58; 76, 78) is provided for three neighboring bonding pads of first, second and third bonding pads (50, 52, 54; 70, 72, 74), and that the P-channel transistor area (58, 78) of said pair is formed adjacent to said first and second neighboring bonding pads (50, 52; 70, 72), and said N-channel transistor area (56, 76) of said pair is formed adjacent to said second and third neighboring bonding pads (52, 54; 72, 74).

7. A semiconductor integrated circuit device as claimed in claim 6, characterized in that said pair of N-channel and P-channel transistor areas (56, 58; 76, 78) is arranged side by side along the arrangement of said first, second and third neighboring bonding pads (50, 52, 54; 70, 72, 74).

8. A semiconductor integrated circuit device as claimed in any of claims 1 to 7, characterized in that each of said paired N-channel and P-channel transistor areas (28, 30; 50, 52, 54; 70, 72, 74) comprises a plurality of source and drain areas (32a, 32b, 34a, 34b; 56a, 56b, 56c, 58a, 58b, 58c; 76a, 76b, 76c; 78a, 78b, 78c) alternately arranged in a direction perpendicular to said first direction.

9. A semiconductor integrated circuit device as claimed in any of claims 1 to 8, characterized in that said semiconductor integrated circuit device is a master slice type semiconductor integrated circuit device.

10. A semiconductor integrated circuit device as claimed in any of claims 1 to 9, characterized by further comprising a gate electrode (42₁ - 42₄; 60, 62; 80, 82) provided for each of said N-channel and P-channel transistor areas (32, 34; 56, 58; 76, 78), and interconnection lines (38a - 38d; 64a - 64g; 84a - 84g) used for coupling said bonding pads (28, 30; 50, 52, 54; 70, 72, 74), said P-channel and N-channel transistor areas, said gate electrodes and said internal logic circuit area.

11. A semiconductor integrated circuit device as claimed in any of claims 1 to 10, characterized in that said peripheral circuit comprises an input buffer circuit for buffering a signal supplied from said external device through one or more of said bonding pads (28, 30; 50, 52, 54; 70, 72, 74).

12. A semiconductor integrated circuit device as claimed in any of claims 1 to 10, characterized in that said peripheral circuit comprises an output buffer circuit for buffering a signal to be output to said external device through one or more of said bonding pads (28, 30; 50, 52, 54; 70, 72, 74).

13. A semiconductor integrated circuit device as claimed in any one of claims 1 to 12, characterized in that said peripheral circuit comprises a bi-directional buffer circuit having the function of outputting and inputting a signal to and from said external device.

## Patentansprüche

1. Integrierte Halbleiterschaltungsvorrichtung, umfassend einen Halbleiterchip (26), der einen internen Logikschaltungsbereich (12) und einen Chip-Peripheriebereich hat, der den internen Logikschaltungsbereich umgibt, sowie Kontaktstreifen (28, 30; 50, 52, 54; 70, 72, 74), die zum Anschluß an eine externe Vorrichtung eingerichtet sind, welche Kontaktstreifen in einer ersten Richtung in einem äußeren Abschnitt des Chip-Peripheriebereiches angeordnet sind; ein Paar eines N-Kanal- und eines P-Kanal-Transistorbereiches (32, 34; 56, 58; 76, 78), welche kontinuierlich in der ersten Richtung gebildet sind und eine Vielzahl von Transistoren enthalten, die für zwei oder mehr benachbarte Kontaktstreifen (28, 30; 50, 52, 54; 70, 72, 74) von den Kontaktstreifen vorgesehen sind und benachbart zu den zwei oder mehr benachbarten Kontaktstreifen in dem Chip-Peripheriebereich angeordnet sind, wobei die Transistoren des Paares von Transistorbereichen mit einer Peripherieschaltung verbunden sind, die mit der externen Vorrichtung durch zwei oder mehr benachbarte Kontaktstreifen verbunden ist, welche Peripherieschaltung mit den zwei oder mehr benachbarten Kontaktstreifen verbunden ist und jeder einzelne der N- und der P-Kanal-Transistorbereiche (32, 34; 56, 58; 76, 78) sich über die Distanz (A) erstreckt, die zwei benachbarte Streifen trennt, dadurch gekennzeichnet, daß die Transistoren in dem Transistorbereich miteinander verbunden sind, so daß sie Pufferschaltungen bilden, die jeweils mit jedem der zwei oder mehr benachbarten Kontaktstreifen verbunden sind.

2. Integrierte Halbleiterschaltungsvorrichtung nach Anspruch 1, dadurch gekennzeichnet, daß das Paar von N-Kanal- und P-Kanal-Transistorbereichen (32, 34) für zwei benachbarte Kontaktstreifen (28, 30) vorgesehen ist und daß einer der paarweise vorliegenden N-Kanal- und P-Kanal-Transistorbereiche direkt benachbart zu den beiden benachbarten Kontaktstreifen ausgebildet ist und der andere Transistorbereich auf einer Seite des einen Transistorbereiches gegenüberliegend einer Seite desselben gebildet ist, welche auf die beiden Kontaktstreifen zu weist.

3. Integrierte Halbleiterschaltungsvorrichtung nach Anspruch 2, dadurch gekennzeichnet, daß das Paar von N-Kanal- und P-Kanal-Transistorbereichen (32, 34) nebeneinander in der zu der ersten Richtung senkrechten Richtung angeordnet ist.

4. Integrierte Halbleiterschaltungsvorrichtung nach Anspruch 2 oder 3, dadurch gekennzeichnet, daß die Breite jedes der paarweise angeordneten N-Kanal- und P-Kanal-Transistorbereiche (32, 34) gleich oder kleiner als die Distanz zwischen Seiten der beiden Kontaktstreifen (28, 30) ist, die einander nicht gegenüberliegen.

5. Integrierte Halbleiterschaltungsvorrichtung nach einem der Ansprüche 2 bis 4, dadurch gekennzeichnet, daß der N-Kanal-Transistorbereich (32) des Paares direkt benachbart zu den zwei benachbarten Kontaktstreifen (28, 30) gebildet ist und der P-Kanal-Transistorbereich (34) des Paares auf der Seite des N-Kanal-Transistorbereiches (32) gebildet ist, die der Seite desselben gegenüberliegt, welche auf die beiden Kontaktstreifen zu weist.

6. Integrierte Halbleiterschaltungsvorrichtung nach Anspruch 1, dadurch gekennzeichnet, daß das Paar von N-Kanal- und P-Kanal-Transistorbereichen (56, 58; 76, 78) für drei benachbarte Kontaktstreifen von ersten, zweiten und dritten Kontaktstreifen (50, 52, 54; 70, 72, 74) vorgesehen ist und daß der P-Kanal-Transistorbereich (58, 78) des Paares benachbart zu dem ersten und dem zweiten benachbarten Kontaktstreifen (50, 52; 70, 72) gebildet ist und der N-Kanal-Transistorbereich (56, 76) des Paares benachbart zu dem zweiten und dem dritten benachbarten Kontaktstreifen (52, 54; 72, 74) gebildet ist.

7. Integrierte Halbleiterschaltungsvorrichtung nach Anspruch 6, dadurch gekennzeichnet, daß das Paar von N-Kanal- und P-Kanal-Transistorbereichen (56 58; 76, 78) nebeneinander entlang der Anordnung der ersten, zweiten und dritten benachbarten Kontaktstreifen (50, 52, 54; 70, 72, 74) angeordnet ist.

8. Integrierte Halbleiterschaltungsvorrichtung nach einem der Ansprüche 1 bis 7, dadurch gekennzeichnet, daß die paarweise vorliegenden N-Kanal- und P-Kanal-Transistorbereiche (28, 30; 50, 52, 54; 70, 72, 74) eine Vielzahl von Source- und Drainzonen (32a, 32b, 34a, 34b; 56a, 56b, 56c, 58a, 58b, 58c; 76a, 76b, 76c; 78a, 78b, 78c) umfassen, die abwechselnd in einer Richtung senkrecht zu der ersten Richtung angeordnet sind.

9. Integrierte Halbleiterschaltungsvorrichtung nach einem der Ansprüche 1 bis 8, dadurch gekennzeichnet, daß die integrierte Halbleiterschaltungsvorrichtung eine integrierte Halbleiterschaltungsvorrichtung des Master-Slice-Typs ist.

10. Integrierte Halbleiterschaltungsvorrichtung nach einem der Ansprüche 1 bis 9, dadurch gekennzeichnet, daß sie ferner eine Gate-Elektrode (42₁ - 42₄; 60, 62; 80, 82) umfaßt, die für jeden der N-Kanal- und P-Kanal-Transistorbereiche (32, 34; 56, 58; 76, 78) vorgesehen ist, sowie Verbindungsleitungen (38a - 38d; 64a - 64g; 84a - 84g), die zum Verbinden der Kontaktstreifen (28, 30; 50, 52, 54; 70, 72, 74), der N-Kanal- und der P-Kanal-Transistorbereiche, der Gate-Elektroden und des internen Logikschaltungsbereiches verwendet werden.

11. Integrierte Halbleiterschaltungsvorrichtung nach einem der Ansprüche 1 bis 10, dadurch gekennzeichnet, daß die Peripherieschaltung eine Eingangspufferschaltung zum Puffern eines von der externen Vorrichtung durch einen oder mehrere der Kontaktstreifen (28, 30; 50, 52, 54; 70, 72, 74) zugeführten Signals umfaßt.

12. Integrierte Halbleiterschaltungsvorrichtung nach einem der Ansprüche 1 bis 10, dadurch gekennzeichnet, daß die Peripherieschaltung eine Ausgangspufferschaltung zum Puffern eines an die externe Vorrichtung durch einen oder mehrere der Kontaktstreifen (28, 30; 50, 52, 54; 70, 72, 74) auszugebenden Signals umfaßt.

13. Integrierte Halbleiterschaltungsvorrichtung nach einem der Ansprüche 1 bis 12, dadurch gekennzeichnet, daß die Peripherieschaltung eine bidirektionale Pufferschaltung umfaßt, die die Funktion der Ausgabe und Eingabe eines Signals an die und von der externen Vorrichtung hat.

## Revendications

1. Dispositif à circuit intégré semiconducteur, comprenant une puce semiconductrice (26) qui possède une zone (12) circuit logique interne et une zone périphérique de puce entourant ladite zone circuit logique interne, ainsi que des plots de liaison (28, 30 ; 50, 52, 54 ; 70, 72, 74) destinés à servir d'interface avec un dispositif externe, lesdits plots de liaison étant disposés suivant une première direction dans une partie externe de ladite zone périphérique de puce ; une paire de zones de transistors à canal N et à canal P (32, 34 ; 56, 58 ; 76, 78) formées de façon continue dans ladite première direction et contenant plusieurs transistors étant prévue pour deux ou plus de deux plots de liaison voisins (28, 30 ; 50, 52, 54 ; 70, 72, 74) parmi lesdits plots de liaison et étant disposée au voisinage desdits deux ou plus de deux plots de liaison voisins dans ladite zone périphérique de puce, lesdits transistors de ladite paire de zones de transistors étant connectés à un circuit peripherique qui sert d'interface avec ledit dispositif externe par l'intermédiaire desdits deux ou plus de deux plots de liaison voisins, ledit circuit péripherique étant connecté auxdits deux ou plus de deux plots de liaison voisins, chacune desdites zones de transistors à canal N et à canal P (32, 34 ; 56, 58 ; 76, 78) s'étendant sur la distance (A) qui sépare lesdits deux plots de liaison voisins, caracterisé en ce que lesdits transistors de ladite zone de transistors sont connectés ensemble de manière à former des circuits tampons qui sont respectivement connectés à chacun desdits deux ou plus de deux plots de liaison voisins.

2. Dispositif à circuit intégré semiconducteur selon la revendication 1, caractérisé en ce que ladite paire de zones de transistors à canal N et à canal P (32, 34) est prévue pour deux plots de liaison voisins (28, 30) et en ce que l'une desdites zones de transistors à canal N et à canal P appariées est formée directement au voisinage desdits deux plots de liaison voisins, et l'autre zone de transistors est formée du côté de ladite zone de transistors citée en premier qui est opposé à son côté regardant lesdits deux plots de liaison voisins.

3. Dispositif à circuit intégré semiconducteur selon la revendication 2, caractérisé en ce que lesdites deux zones appariées de transistors à canal N et à canal P (32, 34) sont disposées côte à côte dans une direction qui est perpendiculaire à ladite première direction.

4. Dispositif à circuit intégré semiconducteur selon la revendication 2 ou 3, caractérisé en ce que la largeur de chacune desdites zones appariées de transistors à canal N et à canal P (32, 34) est égale ou inférieure à la distance comprise entre les côtés desdits deux plots de liaison (28, 30) qui ne sont pas en regard.

5. Dispositif à circuit intégré semiconducteur selon l'une quelconque des revendications 2 à 4, caractérisé en ce que ladite zone de transistors à canal N (32) de ladite paire est formée directement au voisinage desdits deux plots de liaison voisins (28, 30), et ladite zone de transistors à canal P (34) de ladite paire est formée du côté de ladite zone de transistors à canal N (32) qui est opposé à son côté regardant lesdits deux plots de liaison voisins.

6. Dispositif à circuit intégré semiconducteur selon la revendication 1, caractérisé en ce que ladite paire de zones de transistors à canal N et à canal P (56, 58 ; 76, 78) est prévue pour trois plots de liaison voisins, formant un premier, un deuxième et un troisième plot de liaison (50, 52, 54 ; 70, 72, 74), et en ce que la zone de transistors à canal P (58, 78) de ladite paire est formée au voisinage desdits premier et deuxième plots de liaison voisins (50, 52 ; 70, 72), et ladite zone de transistors à canal N (56, 76) de ladite paire est formée au voisinage desdits deuxième et troisième plots de liaison voisins (52, 54 ; 72, 74).

7. Dispositif à circuit intégré semiconducteur selon la revendication 6, caractérisé en ce que lesdites deux zones appariées de transistors à canal N et à canal P (56, 58 ; 76, 78) sont disposées côte à côte le long de la disposition formée par lesdits premier, deuxième et troisième plots de liaison voisins (50, 52, 54 ; 70, 72, 74).

8. Dispositif à circuit intégré semiconducteur selon l'une quelconque des revendications 1 à 7, caractérisé en ce que chacune desdites zones appariées de transistors à canal N et à canal P (28, 30 ; 50, 52, 54 ; 70, 72, 74) comprend plusieurs zones de sources et de drains (32a, 32b, 34a, 34b ; 56a, 56b, 56c, 58a, 58b, 58c ; 76a, 76b, 76c ; 78a, 78b, 78c) alternativement disposées dans une direction perpendiculaire à ladite première direction.

9. Dispositif à circuit intégré semiconducteur selon l'une quelconque des revendications 1 à 8, caractérisé en ce que ledit dispositif à circuit intégré semiconducteur est un dispositif à circuit intégré semiconducteur du type plaquette de circuits intégrés.

10. Dispositif à circuit intégré semiconducteur selon l'une quelconque des revendications 1 à 9, caractérisé en ce qu'il comprend en outre une électrode de grille (42₁ à 42₄ ; 60, 62; 80, 82) prévue pour chacune desdites zones de transistors à canal N et à canal P (32, 34 ; 56, 58 ; 76, 78), et des lignes d'interconnexion (38a à 38d ; 64a à 64g ; 84a à 84g) utilisées pour coupler lesdits plots de liaison (28, 30 ; 50, 52, 54 ; 70, 72, 74), lesdites zones de transistors à canal P et à canal N, lesdites électrodes de grille et ladite zone circuit logique interne.

11. Dispositif à circuit intégré semiconducteur selon l'une quelconque des revendications 1 à 10, caractérisé en ce que ledit circuit périphérique comprend un circuit tampon d'entrée destiné à mettre en tampon un signal délivré par ledit dispositif externe via un ou plusieurs desdits plots de liaison (28, 30 ; 50, 52, 54 ; 70, 72, 74).

12. Dispositif à circuit intégré semiconducteur selon l'une quelconque des revendications 1 à 10, caractérisé en ce que ledit circuit périphérique comprend un circuit tampon de sortie destiné à mettre en tampon un signal devant être délivré audit dispositif externe par l'intermédiaire d'un ou plusieurs desdits plots de liaison (28, 30 ; 50, 52, 54 ; 70, 72, 74).

13. Dispositif à circuit intégré semiconducteur selon l'une quelconque des revendications 1 à 12, caractérisé en ce que ledit circuit périphérique comprend un circuit tampon bidirectionnel ayant pour fonction de délivrer un signal audit dispositif externe et de recevoir un signal de la part de celui-ci.
